# FASCICULE DE BREVET EUROPEEN

(11) **EP 1 456 433 B1**
(45) Date de publication et mention de la délivrance du brevet: **08.11.2006**
(21) Numéro de dépôt: 02799107.4
(22) Date de dépôt: 20.12.2002
(51) Int. Cl.: C23C 16/04, C23C 16/26, C23C 16/44, B01D 53/14

(54) **PROCEDE POUR LE SUIVI DU DEROULEMENT D'UN PROCESSUS UTILISANT UN GAZ REACTIF CONTENANT UN OU PLUSIEURS HYDROCARBURES GAZEUX**
METHODE ZUR BETRIEBSÜBERWACHUNG EINER VERFAHREN MIT VERWENDUNG VON KOHLENWASSERSTOFFHALTIGEN REAKTIVEN GASEN
METHOD FOR MONITORING THE COURSE OF A PROCESS USING A REACTIVE GAS CONTAINING ONE OR SEVERAL HYDROCARBONS

(30) Priorité: 20.12.2001 FR 0116518
(43) Date de publication de la demande: 15.09.2004
(73) Titulaire: Snecma Propulsion Solide, 33187 Le Haillan Cedex (FR)
(72) Inventeur: DELPERIER, Bernard, F-33127 Martignas sur Jalles (FR); THIBAUDEAU, Eric, F-33520 Bruges (FR)
(74) Mandataire: Joly, Jean-Jacques
(86) Numéro de dépôt international: PCT/FR2002/004492
(87) Numéro de publication internationale: WO 2003/054246

(56) Documents cités:
- FR-A- 514 995
- US-A- 5 747 096

## Description

### Arrière-plan de l'invention

L'invention concerne les processus utilisant un gaz réactif contenant un ou plusieurs hydrocarbures gazeux, notamment les processus de cémentation de pièces, de formation de revêtements en carbone pyrolytique sur des substrats par dépôt chimique en phase vapeur, ou encore de densification de substrats poreux par une matrice en carbone pyrolytique formée par infiltration chimique en phase vapeur.

Un domaine particulier, mais non exclusif, d'application de l'invention est la réalisation de pièces en matériau composite comprenant un substrat de renfort fibreux, ou préforme, densifié par une matrice en carbone pyrolytique, en particulier des pièces en matériau composite carbone/carbone (C/C).

Les substrats à densifier sont placés dans un four dans lequel un gaz réactif contenant un ou plusieurs précurseurs est introduit sous pression réduite. Le précurseur est constitué par un ou plusieurs hydrocarbures gazeux, typiquement du méthane, du propane ou un mélange des deux. Les paramètres de fonctionnement du four sont réglés pour produire la matrice de carbone pyrolytique par décomposition (craquage) du gaz précurseur au contact du substrat. Un gaz effluent, contenant des sous-produits de réaction, est extrait du four par pompage.

De façon habituelle, les paramètres de fonctionnement du four, à savoir notamment température du four, pression dans le four, débit du gaz réactif dans le four, composition du gaz réactif, sont constants pendant tout le processus de densification. Or, les conditions d'infiltration changent au fur et à mesure de l'avancement du processus en raison du comblement progressif de la porosité initiale des substrats. Les paramètres choisis résultent donc de la recherche du meilleur compromis entre l'optimum convenant au début de la densification et celui convenant en fin de densification, mais avec un risque de modification de la microstructure du matériau de matrice déposé du fait de la variation de la porométrie des substrats, c'est-à-dire des caractéristiques géométriques de la porosité. Une adaptation des paramètres de fonctionnement du four au cours du déroulement du processus de densification pourrait permettre une optimisation du processus global, de façon à réduire le temps nécessaire pour obtenir un niveau de densification souhaité et à faire en sorte que le matériau de matrice soit formé avec la microstructure souhaitée.

Ainsi, il a été proposé par la déposante, dans le document WO 96/31447, de faire varier les paramètres de fonctionnement du four afin d'optimiser le processus de densification tout en contrôlant la microstructure du matériau de la matrice. Toutefois, cette variation est faite conformément à un modèle pré-établi et ne tient pas compte du déroulement réel du processus.

Il a aussi été proposé dans le document US 5 348 774 de mesurer la variation de poids des substrats de façon continue afin de surveiller l'évolution du processus de densification. En fonction de la variation mesurée, on peut agir sur certains paramètres, notamment la puissance fournie à un inducteur qui, par couplage avec un induit (ou suscepteur) définissant la paroi latérale du four, assure le chauffage de celui-ci. La surveillance de la variation de poids des substrats permet également de détecter la fin du processus de densification. Cela nécessite un aménagement particulier du four permettant de mesurer en continu la masse des substrats, aux température élevées régnant dans le four. Un tel aménagement peut en outre pénaliser la capacité de chargement de substrats dans le volume interne utile du four.

### Objet et résumé de l'invention

L'invention a pour but de proposer un procédé permettant de suivre en continu un processus de densification de substrats par une matrice de carbone pyrolytique, sans nécessiter d'aménagement interne particulier du four d'infiltration.

Plus généralement, l'invention a pour but de proposer un procédé permettant de suivre en continu un processus mis en oeuvre dans un four et utilisant un gaz réactif contenant des hydrocarbures gazeux à température relativement élevée conduisant à la présence de goudrons dans un gaz effluent extrait du four.

Ce but est atteint grâce à un procédé selon lequel, conformément à l'invention, le gaz effluent extrait du four est soumis à un lavage par une huile absorbant des goudrons contenus dans le gaz effluent, et une information sur le déroulement du processus est obtenue à partir d'une mesure de la quantité de goudrons absorbés par l'huile, avantageusement à partir d'une grandeur représentative de la variation dans le temps de la quantité de goudrons absorbés par l'huile.

A cet effet, on peut faire circuler l'huile en circuit fermé et on mesure l'accroissement de volume ou de masse d'huile. Ainsi, selon un mode de réalisation du procédé, l'huile est prélevée en continu dans un bac afin d'être injectée dans un courant de gaz effluent, l'huile chargée de goudrons est retournée dans le bac, et l'information sur le déroulement du processus est obtenue à partir de la mesure de variation de niveau d'huile dans le bac. L'huile peut être injectée dans un courant de gaz effluent circulant dans une colonne de pulvérisation, par exemple une colonne à venturi.

De préférence, l'huile est une huile aromatique capable d'absorber des hydrocarbures aromatiques polycycliques contenus dans le gaz effluent. L'huile peut être notamment choisie parmi des huiles minérales aromatiques telles que par exemple des huiles à base de xylènes.

On peut utiliser l'information obtenue sur le déroulement du processus pour déterminer la fin de ce processus.

On peut aussi contrôler le processus en modifiant, le cas échéant, en fonction de l'information obtenue sur le déroulement du processus, au moins l'un des paramètres suivants de fonctionnement du four : la température du four, la pression dans le four, le débit du gaz réactif dans le four et la composition du gaz réactif.

Le procédé selon l'invention est utilisable notamment pour le suivi de processus de cémentation, de dépôt chimique en phase vapeur ou de densification par infiltration chimique en phase vapeur.

Le suivi d'un processus chimique ou physico-chimique par analyse de sous-produits de réaction dans un effluent d'un four ou réacteur est dans son principe bien connu. Dans le cas particulier d'infiltration chimique en phase vapeur utilisant un gaz réactif contenant des hydrocarbures gazeux tels que méthane et/ou propane, il pourrait être envisagé d'analyser le gaz effluent extrait du four afin de mesurer la quantité d'un sous-produit de réaction particulier produit, par exemple le benzène qui est un bon indicateur du déroulement du processus. Toutefois, une telle mesure serait rendue difficile du fait que le gaz effluent contient de très nombreux hydrocarbures légers et lourds dont des goudrons en quantité relativement importante capables d'encrasser rapidement des canalisations et appareillages de mesure.

La déposante a constaté que le simple suivi de la quantité de goudrons absorbés par une huile de lavage du gaz effluent fournit une indication fiable sur le déroulement du processus, sans faire appel à un appareillage complexe et tout en pouvant s'intégrer dans une installation de traitement du gaz effluent. En effet, afin d'éviter l'encrassement de canalisations et pour satisfaire les exigences en matière environnementale, un traitement du gaz effluent afin d'en éliminer les goudrons est hautement souhaitable. Une élimination par lavage à l'huile est un procédé de traitement efficace. La présente invention peut prendre avantage de la mise en oeuvre d'un tel procédé de traitement pour réaliser, de façon simple et peu coûteuse, un suivi en continu du processus.

### Brève description du dessin

L'invention sera mieux comprise à la lecture de la description faite ci-après, à titre indicatif mais non limitatif, en référence à la Figure unique du dessin annexé qui montre une installation industrielle d'infiltration chimique en phase gazeuse permettant la mise en oeuvre d'un procédé selon l'invention.

### Description détaillée d'un mode de réalisation de l'invention

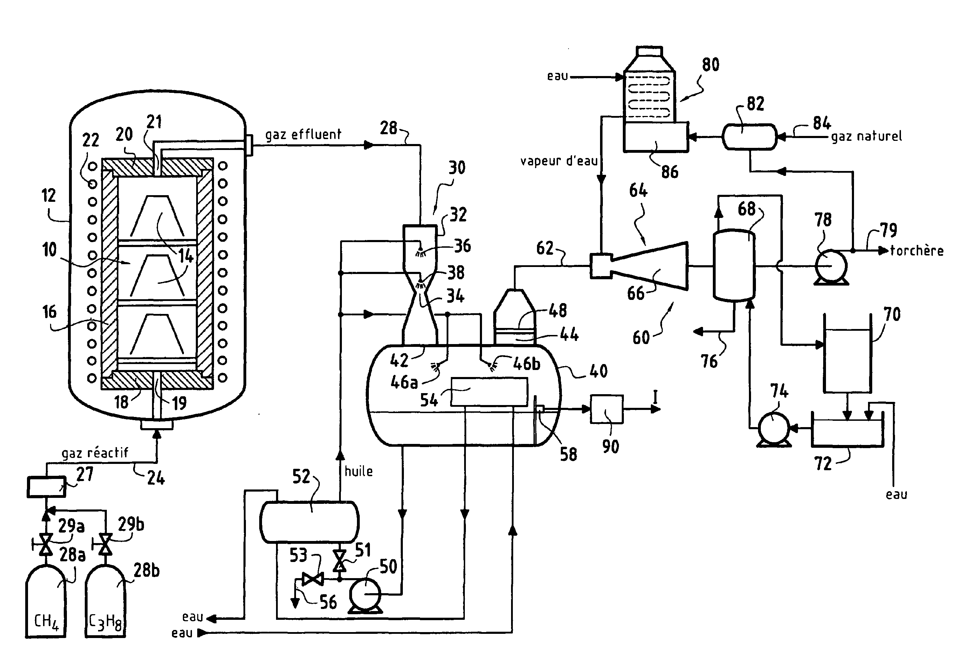

La figure 1 montre de façon très schématique une installation d'infiltration chimique en phase gazeuse destinée à la densification de substrats poreux par une matrice en carbone pyrolytique. Le processus d'infiltration chimique en phase vapeur peut être du type isotherme isobare, c'est-à-dire sans gradient de température ou de pression à travers les substrats, ou du type à gradient de température, c'est-à-dire avec un chauffage non uniforme des substrats, ou encore du type à gradient de pression, c'est-à-dire avec des pressions différentes régnant sur deux faces opposées des substrats.

Un four 10 logé dans une enveloppe 12 reçoit des substrats poreux à densifier 14, par exemple des préformes fibreuses de pièces à réaliser en matériau composite à matrice carbone. Des exemples de préformes fibreuses sont des préformes de divergents ou éléments de divergents de tuyères de moteurs fusées, ou des préformes de disques de freins en composite C/C. Le four 10 est délimité par une paroi latérale 16 formant induit, ou suscepteur, par exemple en graphite, ainsi que par un fond 18 et un couvercle 20, également en graphite. Le suscepteur est couplé avec un inducteur 22 qui l'entoure. Le chauffage du four est assuré par radiation, essentiellement, du suscepteur chauffé par son couplage inductif avec l'inducteur.

Un gaz réactif est introduit par une conduite 24 à travers une entrée 19 formée dans le fond 18 du four. Le gaz réactif comporte un ou plusieurs constituants précurseurs du carbone ainsi qu'un dopant éventuel. Dans l'exemple illustré, le gaz réactif est formé de deux constituants provenant de sources 25a, 25b reliées à la conduite 24 par l'intermédiaire de vannes 26a, 26b et d'un dispositif 27 de mesure de débit. Un gaz effluent est extrait du four à travers une sortie 21 formée dans le couvercle 20 par une conduite 28 reliée à un dispositif de pompage 60 qui assure la circulation du gaz réactif dans le four et maintient à l'intérieur de celui-ci la pression réduite voulue.

Les précurseurs gazeux de carbone pyrolytique sont notamment des alcanes, des alkyles et des alcènes, typiquement du méthane, du propane ou un mélange des deux, produisant du carbone par décomposition (craquage) au contact des substrats à densifier. Le dopant éventuellement associé désigne ici un constituant du gaz réactif qui assure une fonction d'activation du dépôt carbone pyrolytique à partir du ou des précurseurs, dans les conditions opératoires choisies. Le dopant peut aussi constituer un précurseur. Ainsi, dans un gaz réactif comprenant un mélange de méthane et de propane (tous deux précurseurs) issus de sources 28a et 28b, le propane peut jouer le rôle de dopant dans certaines conditions de température et de pression.

Le degré de densification finale des substrats ainsi que la microstructure du carbone pyrolytique sont déterminés notamment par les paramètres de fonctionnement du four que sont :
- la température du four,
- la pression dans le four,
- le débit du gaz réactif dans le four,
- la composition du gaz réactif, à savoir notamment taux de précurseur dans le gaz réactif et taux de dopant éventuel.

Le gaz effluent contient des sous-produits de réaction (craquage) du ou des précurseurs du carbone pyrolytique, une fraction de précurseur(s) n'ayant pas réagi et du gaz hydrogène (H₂) provenant du craquage du ou des précurseurs. Les sous-produits de réaction comportent des hydrocarbures insaturés, des hydrocarbures aromatiques légers (benzène, hydrocarbures monocycliques) et des hydrocarbures aromatiques polycycliques (HAP), tels que notamment le naphtalène, le pyrène, l'anthracène et l'acénaphtylène qui se condensent sous forme de goudrons.

Conformément à l'invention, un suivi du déroulement du processus de densification des substrats est réalisé en soumettant le gaz effluent à un lavage par une huile absorbant ces goudrons et en élaborant une grandeur représentative de la quantité de goudrons absorbés par l'huile.

Ce lavage à l'huile permet en outre d'éliminer les goudrons qui, sinon, encrassent les canalisations de sortie du four et peuvent se retrouver dans le dispositif de pompage utilisé, par exemple dans l'huile de pompe à vide ou dans un condensat d'éjecteur à vapeur.

Un mode de réalisation d'un dispositif de lavage à l'huile 30, interposé entre la sortie de gaz effluent hors du four 10 et le dispositif de pompage 60, est représenté sur la figure annexée. Un tel dispositif est décrit aussi dans la demande de brevet français déposée le même jour que la présente demande et intitulée "procédé et installation pour le traitement de gaz effluent contenant des hydrocarbures".

Le dispositif de lavage à l'huile est placé de préférence à proximité de la sortie du four 10 afin d'éviter la formation de dépôts de goudrons dans la canalisation reliant la sortie du four au dispositif de lavage, ces dépôts étant favorisés par le refroidissement du gaz effluent.

Le dispositif 30 de lavage à l'huile comprend une colonne de pulvérisation 32 qui est reliée à la conduite 26, à sa partie supérieure. La colonne 32 est par exemple une colonne à venturi 34 formé par une restriction de la section de passage pour le gaz. A sa partie inférieure, la colonne 32 communique avec une entrée de gaz 42 formée dans la paroi supérieure d'un bac 40 de recirculation d'huile, au voisinage d'une extrémité de celui-ci. Une sortie de gaz 44 s'ouvre également dans la paroi supérieure du bac 40 et communique par une conduite 42 avec le dispositif de pompage 60.

Une sortie d'huile est formée à la partie inférieure du bac 40 et est reliée à une pompe 50 qui extrait l'huile du bac 40 pour alimenter des buses 36, 38 disposées sensiblement axialement dans la colonne 32, en passant par un échangeur de chaleur 52. Des buses supplémentaires 46a, 46b peuvent être disposées dans le bac 40, les buses 46a, 46b étant alimentées en huile en aval de l'échangeur 52, en parallèle avec les buses 36, 38.

L'échangeur de chaleur 52 est parcouru par un fluide de refroidissement, par exemple de l'eau froide, afin de refroidir l'huile issue du bac 40. L'eau de refroidissement parcourt également un échangeur 54, par exemple sous forme de plaques, qui est en série avec l'échangeur 52 et est disposé à l'intérieur du bac 40.

L'échangeur 54, de même que les buses 46a, 46b, sont logés dans le bac entre l'entrée de gaz 42 et la sortie de gaz 44, au-dessus du niveau de l'huile. Un dévésiculeur 48 peut être monté à la sortie de gaz 44 du bac 40.

Le fonctionnement du dispositif de lavage à huile 30 est le suivant. L'huile amenée aux buses 36, 38 est pulvérisée par le courant de gaz effluent traversant la colonne 32, cette pulvérisation étant favorisée par l'accroissement de vitesse du gaz dû à la présence du venturi. L'une 36 des buses peut être prévue à la partie supérieure de la colonne 32, en amont du venturi 34, et l'autre buse 38 à proximité du col du venturi. On pourra utiliser une seule buse 36 ou 38.

L'huile pulvérisée absorbe une grande partie des goudrons véhiculés par le gaz effluent, en particulier les hydrocarbures aromatiques polycycliques (HAP), qui sont entraînés dans le bain d'huile contenu dans le bac 40.

L'huile utilisée doit présenter une tension de vapeur suffisamment faible pour ne pas se vaporiser à la pression régnant en sortie du four 10, afin de ne pas charger le gaz effluent de vapeur d'huile. A titre indicatif, la pression dans le four 10 lors d'un processus classique de densification de substrats poreux par une matrice de carbone pyrolytique est généralement inférieure à 10,1 kPa. L'huile doit en outre présenter une viscosité suffisamment basse pour être mise en circulation et former un brouillard en sortie des buses.

Pour ces raisons, on utilise de préférence une huile minérale aromatique ayant une tension de vapeur inférieure à 100 Pa à 0°C.

On utilise avantageusement une huile à base de xylènes telle que l'huile de synthèse commercialisée sous la dénomination "Jaritherm AX 320" par la société française Elf Atochem qui est constituée à 85 % en poids de monoxylylxylène et à 15 % en poids de dixylylxylène. Cette huile a une viscosité de 60 centipoises à 0°C et une tension de vapeur à 0°C inférieure à 100 Pa.

Les échangeurs de chaleur 52 et 58 sont alimentés par de l'eau froide à une température proche de 0°C afin de refroidir au maximum l'huile injectée par les buses 36, 38, ainsi que par les buses 46a, 46b sur le trajet entre l'entrée et la sortie de gaz du bac 40.

L'échangeur 54 contribue à favoriser la condensation de goudrons encore présents dans le gaz effluent en sortie de la colonne 32.

Le dévésiculeur 48, par exemple de type à chicanes, contribue à "casser" un brouillard présent en sortie du bac 40 pour séparer les goulettes et provoquer leur coalescence afin de les recueillir dans le bain d'huile.

Le piégeage par le dispositif de lavage à huile 30 permet d'éliminer un maximum de goudrons tels que les HAP. Seuls des hydrocarbures aromatiques plus légers (benzènes, hydrocarbures monocycliques) peuvent subsister dans le gaz effluent lavé, mais ils ne présentent pas de risque d'encrassement de conduites en raison de leur tension de vapeur plus élevée.

Le dispositif de pompage 60 comprend par exemple un éjecteur-condenseur 64, ou plusieurs éjecteurs-condenseurs semblables disposés en série (un seul étant montré sur la figure), étant noté que d'autres dispositifs de pompage peuvent être utilisés, par exemple des pompes rotatives.

L'éjecteur-condenseur 64 comprend une partie éjecteur 66 alimentée en vapeur d'eau par une chaudière 80, et une partie condenseur 68 située en aval de l'éjecteur. Le condenseur 68 est un condenseur indirect, le gaz issu de l'éjecteur étant amené au contact de conduites parcourues par un fluide de refroidissement, par exemple de l'eau froide.

Après passage dans le condenseur 68, l'eau est amenée à une tour de refroidissement 70 d'où elle peut être recueillie dans un bac 72, d'où elle est ramenée au condenseur 68 par une pompe 74.

Le condensat recueilli sur une conduite 76 en sortie du condenseur contient des hydrocarbures tels que benzène, toluène, xylène ainsi que des reliquats éventuels de HAP dissous dans l'eau provenant de la condensation de la vapeur de l'éjecteur 66. Le condensat peut être traité par adsorption sur charbon actif.

En sortie du condenseur, le gaz effluent passe dans une pompe 78. On pourra utiliser une pompe à niveau d'eau refroidi par échangeur de manière que le gaz extrait de l'installation de traitement soit pratiquement à température ambiante.

Le gaz extrait contient essentiellement des hydrocarbures insaturés, en plus du reliquat de gaz réactif et du gaz hydrogène H₂ provenant du four 10. Il peut être dirigé vers une torchère par une conduite 79 et être au moins en partie utilisé comme gaz combustible pour la chaudière 80. Dans ce dernier cas, il est mélangé, dans un ballon tampon 82, avec un combustible gazeux, tel que du gaz naturel, pour alimenter les brûleurs 86 de la chaudière 80.

Dans l'exemple illustré, l'évaluation de la quantité de goudrons absorbés par l'huile de lavage est effectuée par mesure du niveau d'huile dans le bac 40. Un capteur 58 fournit à un circuit de traitement 90 un signal représentatif du niveau d'huile afin d'élaborer une information I utilisable pour effectuer un suivi du processus de densification. Le capteur 58 peut-être de tout type connu, par exemple du type à lame vibrante ou encore du type à radar mesurant, dans ce dernier cas, la distance entre la paroi supérieure du bac, où est logé le détecteur, et la surface de l'huile.

L'information I est par exemple représentative de la dérivée dans le temps du signal représentatif du niveau d'huile, de manière à représenter la variation dans le temps de la quantité de goudrons présents dans le gaz effluent.

Une première possibilité consiste à surveiller l'information I afin de détecter la fin du processus de densification. On pourra considérer le processus de densification comme terminé lorsque la variation du niveau d'huile, c'est-à-dire la variation de la quantité de goudrons présents dans le gaz effluent augmente au-delà d'un seuil donné, par exemple s'accroît de plus de 2 % sur une période d'observation donnée. Celle-ci peut être de une à plusieurs heures, la durée des cycles de densification étant habituellement très longue.

Une autre possibilité, qui peut être exploitée en addition à la première, consiste à contrôler les propriétés de fonctionnement du four en fonction de la valeur de l'information I. Ainsi :
- lorsque la variation du niveau d'huile mesurée sur une période d'observation donnée décroît en deçà d'un seuil Si, par exemple de l'ordre de 0,1 %, on peut agir sur des paramètres de densification (par exemple température, composition du gaz réactif), de manière à amplifier la densification,
- lorsque la variation du niveau d'huile croît au-delà d'un seuil S₂, par exemple de l'ordre de 1 %, on peut agir sur les paramètres de densification de manière à ralentir la densification.

A titre indicatif, pour un débit nominal de 500 l/min de gaz réactif en entrée de four (mélange de méthane et de propane), le seuil S₁ peut correspondre à une diminution de la variation de masse de goudrons de 0,5 g/h à 2 g/h et le seuil S₂ à une augmentation de la variation de masse de goudrons de 5 g/h à 8 g/h.

En fin de processus, une vidange au moins partielle du bac 40 peut être réalisée en sortie de la pompe 50 en fermant une vanne 51 montée sur une conduite reliant la pompe 50 à l'échangeur 52, et en ouvrant une vanne 53 montée sur une conduite reliant la sortie de la pompe 50 à une sortie 56 d'huile usagée. L'huile usagée recueillie peut être détruite par incinération, et de l'huile propre est rajoutée dans le bac 40.

Bien entendu, des moyens autres que la mesure d'augmentation de niveau ou de volume dans un bac de recirculation pourront être prévus pour effectuer un suivi de la quantité d'huile absorbée par l'huile de lavage, par exemple des moyens de mesure de l'accroissement de la masse d'huile.

On notera aussi que la variation du niveau ou de la masse d'huile dans le bac 40 peut être convertie en une grandeur représentative de l'évolution du processus de densification, par exemple en une quantité d'équivalent benzène contenu dans le gaz effluent.

Comme déjà indiqué, le procédé conforme à l'invention peut être mis en oeuvre pour le suivi du déroulement de processus autres que la densification par infiltration chimique en phase vapeur, processus réalisés dans un four en mettant en oeuvre un gaz réactif contenant des hydrocarbures gazeux, notamment du méthane et/ou du propane, à température relativement élevée, et avec production de goudrons dans un gaz effluent. Ces autres processus sont notamment le dépôt chimique en phase vapeur pour la formation de revêtements en carbone pyrolytique sur des substrats, qui est réalisé habituellement à une température d'environ 1000°C ou plus, et la cémentation de pièces dans un four qui peut utiliser un mélange de méthane et de propane à une température d'environ 900°C.

## Revendications

1. Procédé de suivi du déroulement d'un processus mis en oeuvre dans un four et utilisant un gaz réactif contenant au moins un hydrocarbure gazeux, ledit processus comprenant le réglage de paramètres de fonctionnement du four, l'introduction dans le four du gaz réactif contenant au moins un hydrocarbure gazeux, et l'extraction hors du four d'un gaz effluent contenant des sous-produits de réaction du gaz réactif, **caractérisé en ce que** le gaz effluent est soumis à un lavage par une huile absorbant des goudrons contenus dans le gaz effluent, et une information sur le déroulement du processus est obtenue à partir d'une mesure de la quantité de goudrons absorbés par l'huile.

2. Procédé selon la revendication 1, **caractérisé en ce qu'**une information sur le déroulement du processus est obtenue à partir d'une grandeur représentative de la variation dans le temps de la quantité de goudrons absorbés par l'huile.

3. Procédé selon l'une quelconque des revendications 1 et 2, **caractérisé en ce que** l'on fait circuler l'huile en circuit fermé et on mesure l'accroissement de volume d'huile.

4. Procédé selon la revendication 3, **caractérisé en ce que** l'huile est prélevée en continu dans un bac afin d'être injectée dans un courant de gaz effluent, l'huile chargée de goudrons est retournée dans le bac, et l'information sur le déroulement du processus est obtenue à partir de la mesure de variation de niveau d'huile dans le bac.

5. Procédé selon l'une quelconque des revendications 1 et 2, **caractérisé en ce que** l'on fait circuler l'huile en circuit fermé et on mesure l'accroissement de masse d'huile.

6. Procédé selon l'une quelconque des revendications 1 à 5, **caractérisé en ce que** l'huile est injectée dans un courant de gaz effluent circulant dans une colonne de pulvérisation.

7. Procédé selon la revendication 6, **caractérisé en ce que** le gaz effluent circule dans une colonne à venturi.

8. Procédé selon l'une quelconque des revendications 1 à 7, **caractérisé en ce que** l'huile est une huile capable d'absorber des hydrocarbures aromatiques polycycliques contenus dans le gaz effluent.

9. Procédé selon la revendication 8, **caractérisé en ce que** l'huile est choisie parmi des huiles minérales aromatiques.

10. Procédé selon l'une quelconque des revendications 1 à 9, **caractérisé en ce que** l'on utilise l'information obtenue sur le déroulement du processus pour déterminer la fin de ce processus.

11. Procédé selon l'une quelconque des revendications 1 à 10, **caractérisé en ce que** l'on utilise l'information obtenue sur le déroulement du processus pour contrôler le processus modifiant, le cas échéant, en fonction de l'information obtenue sur le déroulement du processus, au moins l'un des paramètres suivants de fonctionnement du four : la température du four, la pression dans le four, le débit du gaz réactif dans le four et la composition du gaz réactif.

12. Utilisation d'un procédé selon l'une quelconque des revendications 1 à 11 pour le suivi d'un processus de densification de substrats poreux par une matrice de carbone pyrolytique formée par infiltration chimique en phase vapeur.

13. Utilisation d'un procédé selon l'une quelconque des revendications 1 à 11 pour le suivi d'un processus de formation d'un revêtement de carbone pyrolytique sur des substrats par dépôt chimique en phase vapeur.

14. Utilisation d'un procédé selon l'une quelconque des revendications 1 à 11 pour le suivi d'un processus de cémentation de pièces.

## Claims

1. A method of monitoring the progress of a process implemented in an oven and using a reagent gas containing at least one gaseous hydrocarbon, said process comprising setting the operating parameters of the oven, introducing the reagent gas containing at least one gaseous hydrocarbon in the oven, and extracting from the oven an effluent gas containing reaction by-products of the reagent gas, the method being **characterised in that** the effluent gas is subjected to washing with an oil that absorbs tars contained in the effluent gas, with information about the progress of the process being obtained by measuring the quantity of tar absorbed by the oil.

2. A method according to claim 1, **characterised in that** information concerning the progress of the process is obtained from a magnitude representative of the variation over time in the quantity of tars absorbed by the oil.

3. A method according to claim 1 or claim 2, **characterised in that** the oil is caused to circulate around a closed circuit and the increase in oil volume is measured.

4. A method according to claim 3, **characterised in that** the oil is taken continuously from a tank so as to be injected into a stream of effluent gas, the oil loaded with tars is returned to the tank, and the information about the progress of the process is obtained by measuring variation in the level of oil in the tank.

5. A method according to claim 1 or claim 2, **characterised in that** the oil is caused to circulate around a closed circuit and the increase in oil weight is measured.

6. A method according to any one of claims 1 to 5, **characterised in that** the oil is injected into a stream of effluent gas flowing in a spray column.

7. A method according to claim 6, **characterised in that** the effluent gas flows through a Venturi column.

8. A method according to any one of claims to 7, **characterised in that** the oil is an oil capable of absorbing polycyclic aromatic hydrocarbons contained in the effluent gas.

9. A method according to claim 8, **characterised in that** the oil is selected from aromatic mineral oils.

10. A method according to any one of claims 1 to 9, **characterised in that** the information obtained about the progress of the process is used to determine the end of the process.

11. A method according to any one of claims 1 to 10, **characterised in that** the information obtained about the progress of the process is used to control the process by modifying, where appropriate and as a function of the information obtained about the progress of the process, at least one of the following parameters concerning oven operation: oven temperature; pressure inside the oven; flow rate of reagent gas through the oven; and the composition of the reagent gas.

12. The use of a method according to any one of claims 1 to 11, for monitoring a process of densifying porous substrates with a pyrolytic carbon matrix formed by chemical vapour infiltration.

13. The use of a method according to any one of claims 1 to 11, for monitoring a process of forming a pyrolytic carbon coating on substrates by chemical vapour deposition.

14. The use of a method according to any one of claims 1 to 11, for monitoring a process of cementing parts.

## Patentansprüche

1. Überwachungsverfahren für den Verlauf eines Prozesses, der in einem Ofen ausgeführt wird und wobei ein reaktionsfähiges Gas, das mindestens einen gasförmigen Kohlenwasserstoff enthält, benutzt wird, wobei der Prozeß die Regelung der Betriebsparameter des Ofens, die Einführung des reaktiven Gases, das mindestens einen gasförmigen Kohlenwasserstoff enthält, in den Ofen und das Abziehen des ausströmenden Gases, das Nebenprodukte der Reaktion des reaktiven Gases enthält, aus dem Ofen umfaßt, **dadurch gekennzeichnet, daß** der Gasabstrom einer Waschung durch ein Öl unterzogen wird, das im ausströmenden Gas enthaltene Teere absorbiert, und eine Information über den Verlauf des Prozesses mittels einer Messung der Menge von Teeren, die von dem Öl absorbiert werden, erhalten wird.

2. Verfahren nach Anspruch 1, **dadurch gekennzeichnet, daß** eine Information über den Verlauf des Prozesses aus einer Größe, die für die zeitliche Variation der Menge der vom Öl absorbierten Teere repräsentativ ist, erhalten wird.

3. Verfahren nach Anspruch 1 und 2, **dadurch gekennzeichnet, daß** man das Öl in geschlossenem Kreislauf zirkulieren läßt und das Anwachsen des Volumens des Öls gemessen wird.

4. Verfahren nach Anspruch 3, **dadurch gekennzeichnet, daß** das Öl kontinuierlich aus einem Becken entnommen wird, um in einen Strom eines Gasabstroms eingespritzt zu werden, das mit Teeren beladene Öl in das Becken rückgeführt wird und die Information über den Verlauf des Prozesses aus der Messung der Ölpegelvariation in dem Becken erhalten wird.

5. Verfahren nach einem der Ansprüche 1 oder 2, **dadurch gekennzeichnet, daß** man das Öl in geschlossenem Kreislauf zirkulieren läßt wird und den Anstieg der Ölmasse mißt.

6. Verfahren nach einem der Ansprüche 1 bis 5, **dadurch gekennzeichnet, daß** das Öl in einen Strom eines Gasabstroms eingespritzt wird, der in einem Zerstäubungsturm zirkuliert.

7. Verfahren nach Anspruch 6, **dadurch gekennzeichnet, daß** der Gasabstrom in einem Venturi-Turm zirkuliert.

8. Verfahren nach einem der Ansprüche 1 bis 7, **dadurch gekennzeichnet, daß** das Öl ein Öl ist, das geeignet ist, polyzyklische aromatische Kohlenwasserstoffe, die in dem Gasabstrom enthalten sind, zu absorbieren.

9. Verfahren nach Anspruch 8, **dadurch gekennzeichnet, daß** das Öl unter aromatischen Mineralölen ausgewählt wird.

10. Verfahren Nach einem der Ansprüche 1 bis 9, **dadurch gekennzeichnet, daß** man die erhaltene Information über den Verlauf des Prozesses benutzt wird, um das Ende dieses Prozesses zu bestimmen.

11. Verfahren nach einem der Ansprüche 1 bis 10, **dadurch gekennzeichnet, daß** die erhaltene Information über den Verlauf des Prozesses benutzt wird, um den Prozeß zu steuern, indem man gegebenenfalls, je nach der erhaltenen Information über den Verlauf des Prozesses, wenigstens einen der folgenden Betriebsparameter des Ofens modifiziert: die Temperatur des Ofens, den Druck in dem Ofen, den Durchsatz des reaktiven Gases in dem Ofen und die Zusammensetzung des reaktiven Gases.

12. Verwendung eines Verfahrens nach einem der Ansprüche 1 bis 11 zur Überwachung eines Prozesses zur Verdichtung von porösen Substraten durch eine Matrix aus pyrolityschem Kohlenstoff, gebildet durch chemische Infiltration in Gasphase.

13. Verwendung eines Verfahrens nach einem der Ansprüche 1 bis 11 zur Überwachung eines Prozesses zur Bildung einer Beschichtung aus pyrolytischem Kohlenstoff auf Substraten durch chemische Abscheidung in Gasphase.

14. Verwendung eines Verfahrens nach einem der Ansprüche 1 bis 11 zur Überwachung eines Prozesses zum Zementieren von Teilen.
